# EUROPÄISCHE PATENTSCHRIFT

(11) **EP 1 252 362 B1**
(45) Veröffentlichungstag und Bekanntmachung des Hinweises auf die Patenterteilung: **02.01.2004**
(21) Anmeldenummer: 01946907.1
(22) Anmeldetag: 29.01.2001
(51) Int. Cl.: C23C 16/448, H01L 21/00

(54) **VERFAHREN UND VORRICHTUNG ZUM ABSCHEIDEN EINES IN FLÜSSIGER FORM VORLIEGENDEN PREKURSORS AUF EINEM SUBSTRAT**
METHOD AND DEVICE FOR DEPOSITING A PRECURSOR ON A SUBSTRATE, SAID PRECURSOR BEING PRESENT IN THE LIQUID FORM
PROCEDE ET DISPOSITIF POUR FAIRE DEPOSER SUR UN SUBSTRAT UN PERCURSEUR SOUS FORME LIQUIDE

(30) Priorität: 28.01.2000 DE 10003758
(43) Veröffentlichungstag der Anmeldung: 30.10.2002
(73) Patentinhaber: Aixtron AG, 52072 Aachen (DE)
(72) Erfinder: LINDNER, Johannes, 52072 Aachen-Richterich (DE); SCHUMACHER, Marcus, 50171 Kerpen (DE); STRZYZEWSKI, Piotr, 52134 Herzogenrath-Kohlscheid (DE); SCHIENLE, Frank, 52064 Aachen (DE); STRAUCH, Gerd, 52072 Aachen (DE); JÜRGENSEN, Holger, 52072 Aachen (DE)
(74) Vertreter: Grundmann, Dirk, Dr.
(86) Internationale Anmeldenummer: PCT/DE2001/000348
(87) Internationale Veröffentlichungsnummer: WO 2001/055478

(56) Entgegenhaltungen:
- EP-A- 0 252 755
- EP-A- 0 666 340
- WO-A-99/02756
- US-A- 5 451 260
- US-A- 5 492 724
- US-A- 5 505 781
- US-A- 5 570 815
- US-A- 5 945 162
- US-A- 6 007 330
- PATENT ABSTRACTS OF JAPAN vol. 1998, no. 13, 30. November 1998 (1998-11-30) & JP 10 229075 A (SHIMADZU CORP), 25. August 1998 (1998-08-25) & US 6 074 487 A (YOSHIOKA ET AL) 13. Juni 2000 (2000-06-13)
- PATENT ABSTRACTS OF JAPAN vol. 1995, no. 06, 31. Juli 1995 (1995-07-31) & JP 07 065991 A (HITACHI ELECTRON ENG CO LTD), 10. März 1995 (1995-03-10)

## Beschreibung

### Technisches Gebiet

Die Erfindung bezieht sich auf eine Vorrichtung zum Abscheiden wenigstens eines in flüssiger oder gelöster Form vorliegenden Prekursors (Vorläufers) auf wenigstens einem Substrat bzw. Wafer gemäß dem Oberbegriff des Patentanspruchs 1 sowie auf ein entsprechendes Verfahren.

Derartige Verfahren und Vorrichtungen werden (u.a.) zur Herstellung von insbesondere dünnen Schichten, wie Halbleiterschichten, supraleitenden Schichten, dielektrischen Schichten usw. auf einem Substrat verwendet.

### Stand der Technik

Ein gattungsgemäßes Verfahren und eine gattungsgemäße Vorrichtung sind (u.a.) aus der WO 95/02711 oder der WO 99/02756 bekannt. Auf diese beiden Druckschriften wird im übrigen zur Erläuterung aller hier nicht näher beschrieben Einzelheiten, zur exemplarischen Erläuterung der einsetzbaren Prekursoren sowie zur Art und Verwendung der herstellbaren Schichten auf Substraten bzw. Wafern unter Verwendung von Prekursoren ausdrücklich Bezug genommen.

Die bekannten Vorrichtungen weisen wenigstens einen Vorratsbehälter für den oder die einzeln oder gemischt vorliegenden Prekursoren auf. Ferner ist in an sich bekannter Weise eine Reaktorkammer vorhanden, in der das oder die Substrate insbesondere auf einem oder mehreren Suszeptoren angeordnet sind, und in der die Schichten auf das Substrat aufgebracht werden sollen.

Eine Fördereinrichtung, die von einer Steuereinheit gesteuert wird, fördert den oder die Prekursoren über wenigstens eine Förderleitung aus dem oder den Vorratsbehältern zu dem Bereich, in dem der oder die Prekursoren verdampft werden sollen.

Bei der aus der WO 95/02711 bekannten Vorrichtung werden der oder die Prekursoren (Vorläufer) in "Form von Tröpfchen" in die Kammer, in der auch die Abscheidung erfolgt, periodisch eingespritzt. Durch die Wahl des Verhältnisses "Einspritzdauer/Periodendauer" wird die Menge der pro Zeiteinheit eingebrachten Prekursoren ungeregelt eingestellt. Weiterhin wird die Kammer, in der auch die Abscheidung erfolgt, von einem Trägergas durchströmt, das die Prekursoren in "Gasform" zu dem oder den Substraten mitschleppt, auf denen die Schicht bzw. die Schichten abgeschieden werden sollen.

Die bekannte Vorrichtung hat damit eine Reihe von Nachteilen:

Durch die periodische Einspritzung können bei bestimmten Prozeßbedingungen Inhomogenitäten entstehen, die sich nachteilig auf die Qualität der hergestellten Schicht auswirken.

Vor allem aber erfolgt keine Überprüfung der tatsächlichen Konzentration der einzelnen Prekursoren, da die Menge, die verdampft wird, ungeregelt eingestellt und nicht überprüft wird. Durch eine Veränderung der in die Reaktorkammer eingebrachten Menge eines Prekursors kann sich die stöchiometrische Zusammensetzung und damit der Aufbau der erzeugten Schicht ungewollt und vor allem nachteilig ändern.

### Darstellung der Erfindung

Der Erfindung liegt die Aufgabe zugrunde, eine gattungsgemäße Vorrichtung sowie ein entsprechendes Verfahren derart weiterzubilden, dass Fehler in der Zusammensetzung der hergestellten Schichten, wie sie beim Stand der Technik auftreten können, vermieden werden.

Eine erfindungsgemäße Lösung für eine Vorrichtung ist im Patentanspruch 1 angegeben. Weiterbildungen der Erfindung sind Gegenstand der abhängigen Ansprüche. Ein erfindungsgemäßes Verfahren ist im Verfahrensanspruch angegeben.

Erfindungsgemäß ist eine Sensoreinheit vorgesehen, die die Menge der pro Zeiteinheit zugeführten Prekursoren erfasst, und deren Ausgangssignal als Ist-Signal an der Steuereinheit anliegt. Die Steuereinheit regelt die Fördereinrichtung derart, dass der Massenstrom der Prekursoren gemittelt über eine bestimmte Zeitdauer einen vorgebbaren Wert hat.

Der vorgebbare Wert, auf den der Massenstrom der Prekursoren gemittelt über eine bestimmte Zeitdauer eingestellt wird, kann selbstverständlich nicht nur ein konstanter, sondern auch ein Zeit- und/oder Schichtdickenabhängiger Wert sein. Weiterhin kann durch eine gezielte Änderungen der Förderleistung und/oder der Temperatur der Prekursoren die pro Zeiteinheit verdampfte Menge des oder der Prekursoren gezielt beeinflusst werden.

Dabei ist nicht nur eine kontinuierliche Förderung, sondern auch eine Förderung möglich, bei der die Steuereinheit zur Regelung des Massenstroms die Förderung von Prekursoren ohne fest vorgegebene Zeitintervalle ein- und ausschaltet.

Zur Durchführung der erfindungsgemäß vorgesehenen Regelungen des (gemittelten) Massenstroms der Prekursoren kann die Sensoreinheit die Menge der zugeführten Prekursoren in der flüssigen Phase erfassen. Besonders bevorzugt ist es jedoch, wenn die Sensoreinheit die Menge der zugeführten Prekursoren in oder nach dem Verdampfungsbereich erfasst. Hierdurch werden nämlich Fehler in der Menge der in die Reaktorkammer eingebrachten Prekursoren, auf die es allein ankommt, vermieden. Derartige nicht reproduzierbare Fehler können beispielsweise durch Rückkondensation auftreten.

Dabei ist es von besonderem Vorteil, wenn die Sensoreinheit die Menge der zugeführten Prekursoren in der verdampften Phase im Bereich eines Gaseinlasses, wie z.B. eines Showerheads, in die Reaktorkammer erfasst, da dann genau die in die Reaktorkammer eingebrachte Menge der verdampften Prekursoren gemessen wird, die durch eine mögliche Rückkondensation nicht mehr beeinflusst wird.

Die Sensoreinheit kann beispielsweise Gewichtssensoren, die das Gewicht der Vorratsbehälter erfassen, Durchflussmesser (insbesondere für die flüssige Phase) und/oder optische Sensoren aufweisen. Optische Sensoren sind besonders geeignet für die Erfassung der Menge der zugeführten Prekursoren in der verdampften Phase.

Bei einer Weiterbildung der Erfindung steuert die Steuereinheit auch die Temperatur der Prekursoren in der flüssigen und/oder der verdampften Phase. Hierbei ist es bevorzugt, wenn die Sensoreinheit die Temperatur des oder der flüssigen Prekursoren in dem oder den Vorratsbehälter(n) und/oder in der oder den Leitung(en) erfasst, und wenn das oder die Ausgangssignale als Ist-Signal an der Steuereinheit anliegen, so dass auch die Temperatur der flüssigen Prekursoren geregelt und nicht nur gesteuert wird. Geeignete Sensoren sind Thermoelemente, Widerstände oder optische Sensoren. Damit wird verhindert, dass die pro Zeiteinheit verdampfte Prekursor-Masse aufgrund von Temperaturänderungen schwankt.

Insbesondere können die Prekursoren auf eine gegebenenfalls vom jeweiligen Ort in der Vorrichtung abhängig vorgebbare Temperatur temperiert werden. Anders ausgedrückt, können die Prekursoren während ihrer Förderung vom Vorratsbehälter zum Verdampfungsbereich ein bestimmtes Temperaturprofil durchlaufen.

Als Fördereinrichtung können die verschiedensten Einrichtungen, wie Pumpen, beispielsweise Kolbenpumpen, Zahnradpumpen, Schlauchpumpen etc. eingesetzt werden. Ferner ist es möglich, dass die Fördereinrichtung den Druck steuert, unter dem die Flüssigkeit im Vorratsbehälter steht. Hierbei ist es beispielsweise möglich, einen druckfesten Vorratsbehälter zu verwenden, und den jeweiligen Prekursor mit einem inerten Gas mit Druck zu beaufschlagen. Weiterhin ist es möglich, die Behälterwände so zu verformen, dass die Flüssigkeit in der gewünschten Weise aus dem Behälter ausfließt. Die Verformung kann dabei derart geschehen, dass sich zu keinem Zeitpunkt eine freie Flüssigkeitsoberfläche bildet, über die der Prekursor kontaminiert werden könnte.

Für die Steuerung des Massenflusses bestehen ebenfalls die verschiedensten Möglichkeiten:

Beispielsweise ist es möglich, dass die Steuereinheit die Fördereinrichtung derart steuert, dass sie den vorgegebenen flüssigen Prekursor-Massenstrom fördert. Weiterhin ist es möglich, dass die Steuereinheit die Fördereinrichtung derart steuert, dass sie einen größeren Massenstrom als den vorgegebenen Massenstrom fördern könnte, und dass wenigstens ein Stellelement vorgesehen ist, das von der Steuereinheit gesteuert wird, und das den flüssigen und/oder gasförmigen Massenstrom des jeweiligen Prekursors auf einen vorgebbaren Wert einstellt bzw. drosselt. Dieses Stellelement kann beispielsweise ein Ventil sein, das in der Förderleitung für den jeweiligen Prekursor vorgesehen ist. Insbesondere kann das Ventil ein Proportionalventil sein, dessen Öffnungsquerschnitt die Steuereinheit steuert. Weiterhin kann das Stellelement einen Injektor, wie beispielsweise eine Düse steuern, der den flüssigen Prekursor in den Verdampfungsbereich einbringt. Die Düse kann dabei eine Zwei- oder Mehrstoffdüse sein, bei der die Flüssigkeit durch einen Gasstrom ausgetragen wird, und die ähnlich wie in der DE-C-41 03 413 beschrieben aufgebaut ist. Insbesondere kann das Trägergas den Gasstrom bilden.

Auch für die Ausbildung des Verdampfungsbereichs bestehen die verschiedensten Möglichkeiten:

Bevorzugt ist es, wenn wenigstens eine Verdampfungskammer vorgesehen ist, in der der Prekursor oder zumindest einer der Mehrzahl von flüssigen Prekursoren verdampft wird, und die mit einem Einlass in die Reaktorkammer, wie beispielsweise einem Showerhead verbunden ist. In diesem Fall ist es auch möglich, dass das Stellelement den Übertritt der verdampften Prekursoren aus der Verdampfungskammer in die Reaktorkammer steuert.

Alternativ können der oder die Injektoren die Prekursoren direkt in die Reaktorkammer einbringen, so dass der Verdampfungsbereich Bestandteil der Reaktorkammer ist.

Bei einer Weiterbildung der Erfindung ist für jeden Prekursor mehr als ein Verdampfungsbereich vorgesehen, dem gegebenenfalls jeweils wenigstens ein Stellelement zugeordnet sein kann.

Wenn mehr als ein Verdampfungsbereich für jeden oder einzelne Prekursoren vorgesehen ist, ist es möglich, dass die Steuereinheit den Massenstrom, der jedem Verdampfungsbereich zugeführt wird, unabhängig von den Massenströmen steuert bzw. regelt, die den anderen Verdampfungsbereichen für den gleichen Prekursor zugeführt werden. Damit kann die Verteilung der Prekursoren in der Reaktorkammer gezielt eingestellt werden. Hierzu ist es bevorzugt, wenn die Sensoreinheit die Verteilung der verdampften Prekursoren in der Reaktorkammer erfasst. Insbesondere kann das Ausgangssignal der Sensoreinheit an der Steuereinheit zur Regelung des jedem der Verdampfungsbereiche zugeführten Massenstroms anliegen.

Bei einer weiteren Ausgestaltung der Erfindung ist eine Temperiereinheit vorgesehen, die die Temperatur der Flüssigkeit in dem oder den Vorratsbehältern, in der oder den Förderleitungen, in dem oder den Stellelementen und/oder in dem oder den Verdampfungsbereichen auf vorgebbare Werte einstellt. Die Temperiereinheit kann eine Kühleinheit aufweisen, die den oder die Prekursor(en) vor dem Verdampfungsbereich auf eine Temperatur unterhalb der Verdampfungstemperatur kühlt. Selbstverständlich ist nicht nur die Einstellung einer konstanten Temperatur, sondern auch von Temperaturprogrammen und/oder Temperaturprofilen längs der Förderstrecke möglich.

Besonders bevorzugt ist es, wenn die Temperiereinheit bei gegebenem Druck in der Reaktorkammer ein derartiges Temperaturprofil einstellt, dass die Temperatur im Verdampfungsbereich des bzw. der Prekursoren oberhalb der Verdampfungstemperatur liegt. Hierzu können im Verdampfungsbereich temperierbare Flächen angeordnet sein. Die Flächen können über eine Widerstandsheizung elektrisch oder durch Strahlung oder in sonstiger Weise direkt oder indirekt beheizt werden.

Bei Verwendung von mehr als einem Prekursor können die Prekursoren gemischt in den Vorratsbehältern vorliegen und/oder verschiedene jeweils in getrennten Vorratsbehältern gespeicherte Prekursoren entsprechend einem vorgebbaren Mischungsverhältnis im flüssigen bzw. gasförmigen Zustand, im Verdampferbereich, im Bereich des Gaseinlasses (Showerhead) in die Reaktorkammer und/oder erst in der Reaktorkammer gemischt werden. Auch kann zwischen unterschiedlichen Vorratsbehältern zur Herstellung unterschiedlicher Schichten "umgeschaltet" werden.

Selbstverständlich ist nicht nur die Verwendung von flüssigen Prekursoren möglich. Zusätzlich können auch Stoffe als Schicht-bildende Stoffe eingesetzt werden, die gasförmig sind. Hierzu kann in der Reaktorkammer und/oder im Verdampfungsbereich wenigstens ein Einlass für ein Trägergas und/oder ein Prozessgas vorgesehen sein.

### Kurze Beschreibung der Zeichnung

Die Erfindung wird nachstehend exemplarisch anhand der Zeichnung beschrieben, in der zeigen:
- Fig. 1: den prinzipiellen Aufbau einer Vorrichtung, bei der die Erfindung einsetzbar ist,
- Fig. 2: exemplarisch den Aufbau einer Reaktorkammer,
- Fig. 3a und 3b: die Ausbildung einer erfindungsgemäß vorgesehenen Sensoreinheit

### Darstellung eines Ausführungsbeispiels

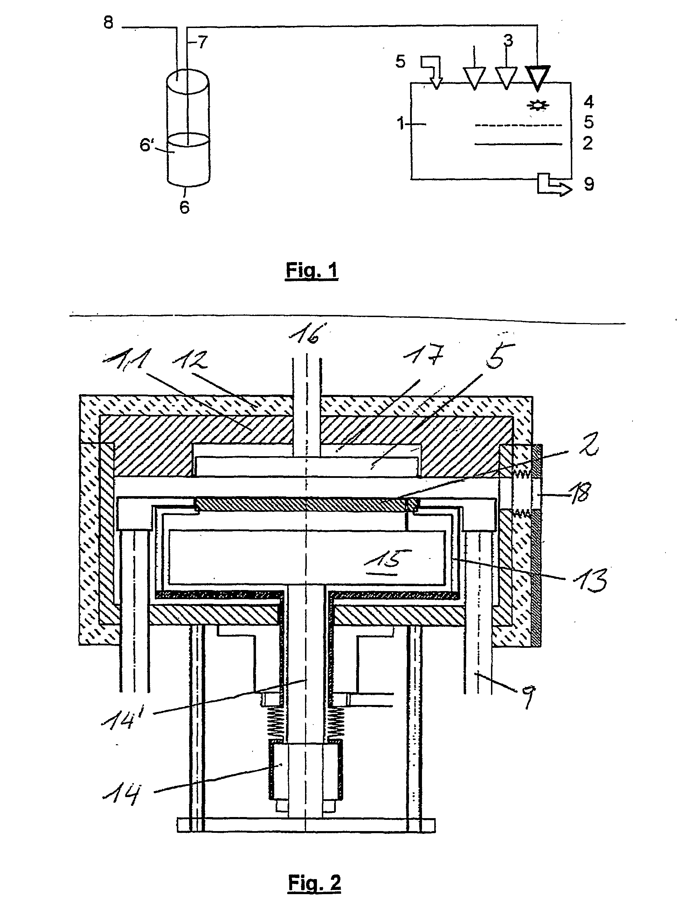

Fig. 1 zeigt den prinzipiellen Aufbau einer Vorrichtung zum Abscheiden von Schichten auf einem Substrat. Die Vorrichtung weist eine Reaktorkammer 1 auf, in der auf (wenigstens) einem Suszeptor 2 ein oder mehrere (nicht dargestellte) Substrate angeordnet sind, auf denen wenigstens eine Schicht mit dem erfindungsgemäßen Verfahren abgeschieden werden soll.

Hierzu weist die Reaktorkammer 1 (bei dem gezeigten Ausführungsbeispiel und ohne Beschränkung der Zahl der möglichen Injektoren) drei Injektoren 3 auf, mittels derer in flüssiger oder gelöster Form vorliegende (unterschiedliche oder gleiche) Prekursoren bzw. Vorläufer-Substanzen in einen oder mehrere (nur schematisch dargestellte) Verdampfungsbereiche 4 gefördert werden. Bei dem gezeigten Ausführungsbeispiel werden die nach dem Verdampfungsbereich 4 in gasförmiger Form vorliegenden Prekursoren über (ebenfalls nur schematisch dargestellte) Auslässe 5, die beispielsweise so genannte Showerheads sein können, derart in das Innere der Reaktorkammer 1 eingeleitet, dass sie so über das oder die auf dem Suszeptor 2 angeordneten Substrate verteilt werden, dass sich eine homogene Schicht auf dem oder den Substraten (beispielsweise Wafern) bildet. Zusätzlich ist (wenigstens) ein Gas-Auslass 6 vorgesehen, durch den ein Trägergas oder ein Prozessgas in das Innere der Reaktorkammer 1 eintreten kann. Die in der Reaktorkammer befindlichen Gase werden über einen Auslass 9 wieder aus der Reaktorkammer 1 abgeführt.

Für jeden der Prekursoren oder Prekursor-Mischungen, die zu (wenigstens) einem der Injektoren 3 gefördert werden sollen, ist ein Vorratstank 6 vorgesehen, der über eine Leitung 7 mit einem in die in dem Vorratstank 6 befindliche Flüssigkeit 6' ragenden Tauchrohr mit dem oder den jeweiligen Injektoren 3 verbunden ist. Dabei kann ein Injektor nacheinander mit unterschiedlichen Vorrattanks verbunden werden. Zur Förderung des jeweiligen Prekursors 6' aus dem jeweils mit dem Injektor verbundenen Vorratstank 6 in die Leitung 7 ist ein Druckrohr 8 vorgesehen, über das die Flüssigkeit 6' in dem Vorratstank mit einem von einer nicht dargestellten Steuereinheit steuerbaren Druck beaufschlagt wird, so dass sie mit einer bestimmten Fördermenge pro Zeiteinheit durch die Leitung 7 zum jeweiligen Injektor 3 gefördert wird. Selbstverständlich sind aber auch andere Fördereinrichtung möglich.

Der vorstehend beschriebene Grundaufbau der Vorrichtung ist prinzipiell bekannt.

Fig. 2 zeigt exemplarisch einen (möglichen) Aufbau der Reaktorkammer 1. In einem Gehäuse 11 mit einer thermischen Isolierung 12 ist der Suszeptor bzw. die Waferaufnahme 2 auf einem Suszeptor-Träger 13 angeordnet. Bei dem gezeigten Ausführungsbeispiel wird der Träger 13 von einer Drehvorrichtung 14 gedreht, so dass er zusammen mit dem Suszeptor 2 um die Drehachse 14' rotiert. Zusätzlich können in an sich bekannter Weise auf dem Suszeptor sogenannte Planeten angeordnet sein, die beispielsweise mittels eines Gasstromes ("Gasfoil") zu einer Drehung um eine von der Drehachse 14' beabstandete Achse angetrieben werden, und auf denen dann die (auch in Fig. 2 nicht dargestellten) Substrate angeordnet sind. Derartige Reaktoren werden auch als Planetenreaktoren bezeichnet und von der Aixtron AG, Aachen, DE hergestellt. Auf die Ausbildung dieser bekannten Planetenreaktoren wird Bezug genommen.

Ausdrücklich soll jedoch darauf hingewiesen werden, dass die Ausbildung des oder der Suzeptoren für die Erfindung nicht ausschlaggebend ist, und dass selbstverständlich auch anders ausgebildete Reaktorkammern eingesetzt werden können: So ist es beispielsweise möglich, horizontale Reaktoren, bei denen sich der oder die Suszeptoren nicht drehen, oder vertikale Reaktoren zu verwenden, bei denen die Substrate senkrecht angeordnet sind.

In an sich bekannter Weise weist der in Fig. 2 exemplarisch als mögliche Reaktorkammer dargestellte Reaktor 1 eine Heizung 15, beispielsweise eine oder mehrere IR-Lampen, für den oder die Suszeptoren 2 sowie gegebenenfalls ein nicht näher dargestelltes Temperiersystem für das Gehäuse 11 auf, mit dem das Gehäuse 11 auf eine bestimmte Temperatur und insbesondere auf ein (örtlich variabel) vorgebbares Temperaturprofil einstellbar ist.

Weiter ist ein Gaseinlasssystem vorgesehen, das in Fig. 2 nur schematisch für einen oder mehrere (bereits gasförmige) Prekursoren dargestellt ist. Dieses Gaseinlasssystem weist ein Zuführungsrohr 16 auf, das den in Fig. 2 nicht dargestellten Verdampfer bzw. Verdampfungsbereich 4 mit einem nur schematisch dargestellten Showerhead 5 verbindet, aus dem der oder die jeweiligen Prekursoren in das Innere der Reaktorkammer 1 mit einem Strömungsprofil eintreten, das zu einer homogenen Verteilung der einzelnen Atome bzw. Verbindungen auf der Waferoberfläche und damit zu einer homogenen Schichtbildung führt.

Im Falle der Verwendung von zwei oder mehr Prekursoren können die Prekursoren und gegebenenfalls Prozess- oder Trägergase im Inneren des Showerheads - hierzu sind mehrere Zuführungsrohre erforderlich - oder bereits im Verdampfungsbereich oder sogar im Vorratstank oder in der flüssigen Phase - beispielsweise mittels statischen Mischelementen - gemischt werden, so dass die (bereits) gemischten Prekursoren (in gasförmiger Form) und/oder Prozess- und/oder Trägergase durch ein einzigen Zuführungsrohr 16 dem (dann einzigen) Showerhead 5 zugeführt werden.

Alternativ können bei der Verwendung mehrerer Prekursoren mehrere Zuführungsrohre 16 verwendet werden, die mehrere getrennte Verdampfungsbereiche 4 mit einem oder mehreren Showerheads 5 verbinden. Im Falle der Verwendung mehrerer Showerheads können diese dann so ausgebildet sein, dass ihre Gasauslassöffnungen hin zum Inneren der Reaktorkammer 1 "verschachtelt" angeordnet sind, so dass eine Mischung der einzelnen gasförmigen Prekursoren (und gegebenenfalls weiterer Prozessgase) erst im Inneren der Reaktorkammer 1 erfolgt.

Oberhalb des Showerheads 5 ist bei dem gezeigten Ausführungsbeispiel ein Volumen 17 vorgesehen, das unterschiedlich verwendet werden kann:

Das Volumen 17 kann beispielsweise dazu genutzt werden, ein Gas einzubringen. Über den Gasdruck in dem Volumen 17 kann die Wärmeleitung zwischen dem Showerhead 5 und dem temperierten Gehäuse 11 so eingestellt werden, dass der Showerhead 5, der auch mit dem oder den Prozessgasen Wärmeenergie austauscht, eine im Hinblick auf die Prozessbedingungen bevorzugte Temperatur annimmt.

Alternativ (oder zusätzlich) können in das Volumen 17 Prozess- und/oder Trägergase eingeleitet werden können, die dann an den Rändern des Showerheads - gegebenenfalls über geeignete Drosseln - in das Innere der Reaktorkammer 1 eintreten.

Auch eine Kombination aller vorstehend genannten Möglichkeiten ist einsetzbar:

So können einzelne Prekursoren bereits in einem bestimmten Vorratstank gemischt werden, weitere Prekursoren, die einzeln in Vorratstanks bevorratet werden, können in flüssiger Form - beispielsweise mit den bereits erwähnten statischen Mischelementen - und/oder im Verdampfungsbereich und/oder im Showerhead und/oder in der Reaktorkammer "zugemischt" werden. Auch ist es möglich, an jeder Stelle, an der die Prekursoren bereits in gasförmiger Form vorliegen, Prozess- und/ oder Trägergase zuzumischen. Ferner ist es möglich, zwischen Vorrattanks mit unterschiedlichen Prekursoren umzuschalten, so dass über ein- und denselben Injektor nacheinander unterschiedliche Prekursoren verdampft werden, die zu unterschiedlichen Schichten führen.

Unabhängig von der genauen Ausbildung der Vorrichtung ist ein genaues Einhalten der Konzentration der einzelnen Prekursoren in der Reaktorkammer über dem oder den Substraten bzw. Wafern erforderlich.

Erfindungsgemäß wird die Einhaltung der Konzentration der einzelnen benötigten Prekursoren dadurch gewährleistet, dass anstelle einer einfachen Steuerung eine Regelung des Massenstroms der Prekursoren erfolgt:

Hierzu ist eine Sensoreinheit vorgesehen, die die Menge der zugeführten Prekursoren erfasst, und deren Ausgangssignal als Ist-Signal an der Steuereinheit zur Regelung des Massenstromes anliegt.

Dabei kann die Sensoreinheit die Menge der zugeführten Prekursoren in der flüssigen Phase erfassen.

Von besonderem Vorteil ist es jedoch, wenn die Sensoreinheit die Menge der zugeführten Prekursoren in der verdampften Phase so nah wie möglich am Substrat erfasst, da dann die Konzentrationsfehler in der hergestellten Schicht aufgrund von Rückkondensation eines oder mehrerer Prekursoren so gering wie möglich sind.

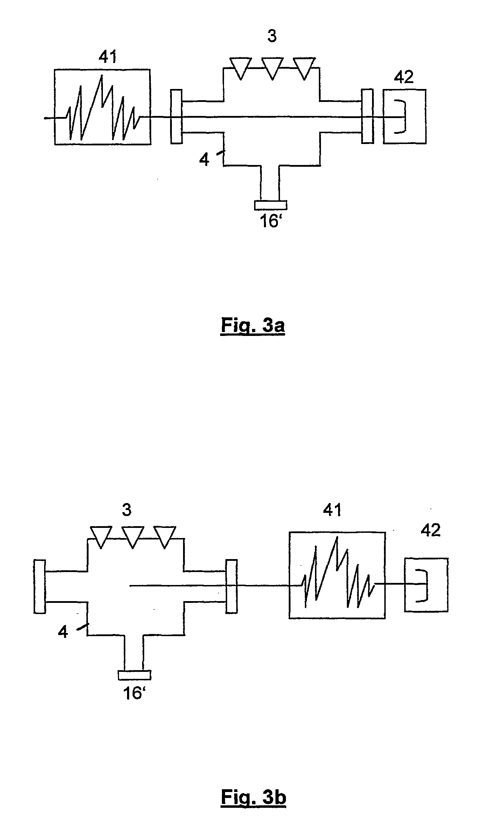

Hierzu kann die Sensoreinheit im Bereich eines Gaseinlasses, wie z.B. des Showerheads 5, in die Reaktorkammer 1 angeordnet werden. Bei der in Fig. 2 dargestellten Reaktorkammer 1 ist hierzu an der Seite ein Fenster 18 vorgesehen, das beispielsweise eine optische Bestimmung der Konzentration der einzelnen Prekursoren z.B. auf die in Verbindung mit den Fig. 3a und 3b beschriebenen Weise erlaubt. Diese Vorgehensweise hat den Vorteil, dass genau die in die Reaktorkammer 1 eingebrachte Menge der verdampften Prekursoren erfasst wird.

Alternativ ist es möglich, die Menge der in der oder den Verdampferbereichen 4 verdampften Prekursoren zu erfassen. Dies kann beispielsweise über eine - gegebenenfalls ortsauflösende - Druckmessung oder andere Verfahren - beispielsweise unter Verwendung von Ellipsometern - erfolgen.

Besonders vorteilhaft sind jedoch optische Messungen, wie sie exemplarisch in den Fig. 3a und 3b dargestellt sind.

In den Fig. 3a und 3b ist schematisch ein Verdampferbereich 4, der als gesonderte Kammer ausgebildet ist, dargestellt. In die Verdampferkammer 4 münden die bereits erwähnten Injektoren 3. Auf der gegenüberliegenden Seite ist ein Auslass 16' vorgesehen, der beispielsweise mit der Leitung 16 (Fig. 2) verbunden ist, und durch den der oder die verdampften Prekursoren aus der Kammer austreten.

Zur Erfassung der Menge der verdampften Prekursoren sind ein Interferometer 41 und ein Detektor 42 vorgesehen, die eine FTIR-Sensoreinheit bilden und bei dem in Fig. 3a gezeigten Ausführungsbeispiel beidseits der Kammer 4 und bei dem in Fig. 3b gezeigten Ausführungsbeispiel auf der einen Seite der Kammer 4 angeordnet sind.

In beiden Fällen ist ein präzise Erfassung der in der Kammer 4 vorhandenen Prekursor-Menge interferometrisch möglich.

Das Ausgangssignal des Detektors 42 liegt an der nicht dargestellte Steuereinheit zur Regelung des Massenstroms des oder der Prekursoren an.

Zusätzlich kann die Wand der Verdampferkammer 4 mit einer Heizung und Temperatursensoren versehen sein, so dass die Wand auf eine für die Prozessführung optimale Temperatur geregelt werden kann.

Vorstehend ist die Erfindung anhand eines Ausführungsbeispiels ohne Beschränkung des allgemeinen Erfindungsgedankens beschrieben, wie er sich aus den Ansprüchen ergibt.

Unabhängig von der Formulierung der Ansprüche wird rein vorsorglich die Beanspruchung weiterer, nicht in den Ansprüchen enthaltener Erfindungsgedanken beansprucht.

## Patentansprüche

1. Vorrichtung zum Abscheiden wenigstens eines in flüssiger oder gelöster Form vorliegenden Prekursors auf wenigstens einem Substrat, mit
- wenigstens einem Vorratsbehälter (6) für den oder die einzeln oder gemischt vorliegenden Prekursoren (6'),
- einer Reaktorkammer (1), in dem das oder die Substrate angeordnet sind, auf das oder die wenigstens eine Schicht aufgebracht werden soll,
- einer Fördereinrichtung (8), die den oder die Prekursoren (6') über wenigstens eine Leitung (7) aus dem oder den Vorratsbehältern (6) zu wenigstens einem Bereich (4) fördert, in dem der oder die Prekursoren (6') verdampft werden sollen, und
- einer Steuereinheit, die die Fördereinrichtung (8) steuert,
**dadurch gekennzeichnet, dass** eine Sensoreinheit (41, 42) vorgesehen ist, die die Menge der pro Zeiteinheit zugeführten Prekursoren erfasst, und deren Ausgangssignal als Ist-Signal an der Steuereinheit anliegt, und
dass die Steuereinheit die Fördereinrichtung (8) derart regelt, dass der Massenstrom der Prekursoren gemittelt über eine bestimmte Zeitdauer einen vorgebbaren Wert hat.

2. Vorrichtung nach Anspruch 1,
**dadurch gekennzeichnet, dass** die Steuereinheit zur Regelung des Massenstroms die Förderung von Prekursoren ohne fest vorgegebene Zeitintervalle einund ausschaltet.

3. Vorrichtung nach Anspruch 1,
**dadurch gekennzeichnet, dass** die Steuereinheit zur Regelung des Massenstroms die kontinuierliche Förderung von Prekursoren bewirkt.

4. Vorrichtung nach einem der Ansprüche 1 bis 3,
**dadurch gekennzeichnet, dass** die Fördereinrichtung eine Pumpe ist.

5. Vorrichtung nach einem der Ansprüche 1 bis 3,
**dadurch gekennzeichnet, dass** die Fördereinrichtung (8) den Druck steuert, unter dem die Flüssigkeit (6') im Vorratsbehälter (6) steht.

6. Vorrichtung nach einem der Ansprüche 1 bis 5,
**dadurch gekennzeichnet, dass** die Steuereinheit zur Regelung des Massenstromes die Fördereinrichtung steuert.

7. Vorrichtung nach einem der Ansprüche 1 bis 5,
**dadurch gekennzeichnet, dass** die Steuereinheit die Fördereinrichtung derart steuert, dass sie einen größeren Massenstrom als den vorgegebenen Massenstrom fördern könnte, und
dass wenigstens ein Stellelement vorgesehen ist, das zur Regelung des Massenstroms von der Steuereinheit gesteuert wird, und das den Massenstrom des jeweiligen Prekursors auf einen vorgebbaren Wert einstellt.

8. Vorrichtung nach Anspruch 7,
**dadurch gekennzeichnet, dass** das Stellelement ein Ventil ist, das in der Leitung für den jeweiligen Prekursor vorgesehen ist.

9. Vorrichtung nach Anspruch 8,
**dadurch gekennzeichnet, dass** das Ventil ein Proportionalventil ist, dessen Öffnungsquerschnitt die Steuereinheit steuert.

10. Vorrichtung nach Anspruch 7,
**dadurch gekennzeichnet, dass** das Stellelement einen Injektor steuert, der den flüssigen Prekursor in den Verdampfungsbereich einbringt.

11. Vorrichtung nach einem der Ansprüche 1 bis 10,
**dadurch gekennzeichnet, dass** wenigstens eine Verdampfungskammer (4) vorgesehen ist, in der der Prekursor (6') oder zumindest einer der Mehrzahl von flüssigen Prekursoren verdampft, und die mit wenigstens einem Einlass in die Reaktorkammer (1), wie beispielsweise einem Showerhead (5) verbunden ist.

12. Vorrichtung nach Anspruch 11,
**dadurch gekennzeichnet, dass** das Stellelement den Übertritt der verdampften Prekursoren aus der Verdampfungskammer in die Reaktorkammer steuert.

13. Vorrichtung nach einem der Ansprüche 1 bis 11,
**dadurch gekennzeichnet, dass** der oder die Injektoren den oder die Prekursoren direkt in die Reaktorkammer einbringen, so dass der Verdampfungsbereich Bestandteil der Reaktorkammer ist.

14. Vorrichtung nach einem der Ansprüche 1 bis 13,
**dadurch gekennzeichnet, dass** die Injektoren Zweistoff- oder Mehrstoffdüsen sind, und
dass ein Stoff das Trägergas ist.

15. Vorrichtung nach einem der Ansprüche 1 bis 14,
adurch gekennzeichnet, dass die Sensoreinheit die Menge der zugeführten Prekursoren in der flüssigen Phase erfasst.

16. Vorrichtung nach einem der Ansprüche 1 bis 14,
**dadurch gekennzeichnet, dass** die Sensoreinheit die Menge der zugeführten Prekursoren in oder nach dem Verdampfungsbereich erfasst.

17. Vorrichtung nach Anspruch 16,
**dadurch gekennzeichnet, dass** die Sensoreinheit die Menge der zugeführten Prekursoren in der verdampften Phase im Bereich eines Gaseinlasses in die Reaktorkammer, wie z.B. des Showerheads (5) erfasst.

18. Vorrichtung nach einem der Ansprüche 1 bis 17,
**dadurch gekennzeichnet, dass** die Steuereinheit die Temperatur des bzw. der Prekursoren auf jeweils - gegebenenfalls örtlich - vorgebbare Werte steuert.

19. Vorrichtung nach Anspruch 18,
**dadurch gekennzeichnet, dass** die Sensoreinheit die Temperatur des oder der flüssigen Prekursoren in dem oder den Vorratsbehälter(n) und/oder in der oder den Leitung(en) erfasst.

20. Vorrichtung nach Anspruch 19,
**dadurch gekennzeichnet, dass** das Ausgangssignal der Temperatur-Sensoreinheit als Ist-Signal an der Steuereinheit anliegt.

21. Vorrichtung nach Anspruch 19 oder 20,
**dadurch gekennzeichnet, dass** die Steuereinheit die Temperatur der Prekursoren auf jeweils vorgebbare Werte steuert.

22. Vorrichtung nach einem der Ansprüche 1 bis 21,
**dadurch gekennzeichnet, dass** für jeden Prekursor mehr als ein Verdampfungsbereich vorgesehen ist.

23. Vorrichtung nach Anspruch 22,
**dadurch gekennzeichnet, dass** die Steuereinheit den Massenstrom, der jedem Verdampfungsbereich zugeführt wird, unabhängig von den Massenströmen steuert bzw. regelt, die den anderen Verdampfungsbereichen für den gleichen Prekursor zugeführt werden.

24. Vorrichtung nach einem der Ansprüche 1 bis 23,
**dadurch gekennzeichnet, dass** die Sensoreinheit die Verteilung der verdampften Prekursoren in der Reaktorkammer erfasst.

25. Vorrichtung nach Anspruch 24,
**dadurch gekennzeichnet, dass** das Ausgangssignal der Sensoreinheit an der Steuereinheit zur Regelung des jedem der Verdampfungsbereiche zugeführten Massenstroms anliegt.

26. Vorrichtung nach einem der Ansprüche 1 bis 25,
**dadurch gekennzeichnet, dass** eine Temperiereinheit vorgesehen ist, die die Temperatur der Flüssigkeit in dem oder den Vorratsbehältern, in der oder den Zuleitungen, in dem oder den Stellelementen und/oder in dem oder den Verdampfungsbereichen auf vorgebbare Werte einstellt.

27. Vorrichtung nach Anspruch 26,
**dadurch gekennzeichnet, dass** die Temperiereinheit eine Kühleinheit aufweist, die den oder die Prekursor(en) vor dem Verdampfungsbereich auf eine Temperatur unterhalb der Verdampfungstemperatur bei dem Druck im Verdampfungsbereich kühlt.

28. Vorrichtung nach Anspruch 26 oder 27,
**dadurch gekennzeichnet, dass** die Temperiereinheit bei gegebenem Druck in der Reaktorkammer ein derartiges Temperaturprofil einstellt, dass die Temperatur im Verdampfungsbereich des bzw. der Prekursoren oberhalb der Verdampfungstemperatur für den jeweiligen Druck im Verdampfungsbereich liegt.

29. Vorrichtung nach Anspruch 28,
**dadurch gekennzeichnet, dass** im Verdampfungsbereich temperierbare Flächen angeordnet sind.

30. Vorrichtung nach einem der Ansprüche 1 bis 29,
**dadurch gekennzeichnet, dass** bei Verwendung von mehr als einem Prekursor die Prekursoren gemischt in den Vorratsbehältern vorliegen und/oder verschiedene jeweils in getrennten Vorratsbehältern gespeicherte Prekursoren entsprechend einem vorgebbaren Mischungsverhältnis im flüssigen Zustand, im Verdampferbereich, im Bereich des Gaseinlasses (Showerhead) in die Reaktorkammer und/oder erst in der Reaktorkammer gemischt werden.

31. Vorrichtung nach Anspruch 30,
**dadurch gekennzeichnet, dass** statische Mischelemente vorgesehen sind, die die Mischung der einzelnen flüssigen Prekursoren bewirken.

32. Vorrichtung nach einem der Ansprüche 1 bis 31,
**dadurch gekennzeichnet, dass** in der Reaktorkammer und/oder dem oder den Verdampfungsbereich wenigstens ein Einlass für ein Trägergas und/oder ein Prozessgas vorgesehen ist.

33. Vorrichtung nach einem der Ansprüche 5 bis 32,
**dadurch gekennzeichnet, dass** sich der Prekursor in einem verformbaren Behälter, der in einem druckfesten Gefäß angeordnet ist, und dass der Behälter zur Förderung des Prekursors derart von einem in dem Gefäß befindlichen Gas beaufschlagt wird, dass sich keine freie Flüssigkeitsoberfläche ergibt.

34. Verfahren zum Abscheiden wenigstens eines in flüssiger oder gelöster Form vorliegenden Prekursors auf wenigstens einem Substrat, bei dem die einzeln oder gemischt vorliegenden Prekursoren von einer Fördereinrichtung über wenigstens eine Leitung in wenigstens einen Verdampfungsbereich gefördert werden, so dass sie die Schichten auf dem in einer Reaktorkammer angeordneten Substrat bilden,
**dadurch gekennzeichnet, dass** die Menge der zugeführten Prekursoren erfasst wird, und, dass der Massenstrom der Prekursoren gemittelt über eine bestimmte Zeitdauer auf einen vorgebbaren Wert eingestellt wird.

35. Verwendung des Verfahrens nach Anspruch 34 zur Herstellung dünner Schichten auf Substraten.

## Claims

1. A device for depositing at least one precursor, which is in liquid or dissolved form, on at least one substrate, having
- at least one reservoir (6) for the precursor(s) (6'), which is/are in individual or mixed form,
- a reactor chamber (1), in which the substrate(s), to which at least one film is to be applied, are disposed,
- a delivery device (8), which delivers the precursor(s) (6') via at least one line (7) from the reservoir(s) (6) to at least one region (4) in which the precursor(s) (6') are to be evaporated, and
- a control unit which controls the delivery device (8),
**characterized in that** there is a sensor unit (41, 42), which records the quantity of precursors supplied per unit time and the output signal from which is applied to the control unit as an actual signal, and
**in that** the control unit regulates the delivery device (8) in such a manner that the mass flow of precursors, taken as a mean over a defined period of time, has a predeterminable value.

2. The device according to claim 1, **characterized in that** the control unit switches the delivery of precursors on and off, without fixedly predetermined time intervals, in order to regulate the mass flow.

3. The device according to claim 1, **characterized in that** the control unit effects continuous delivery of precursors in order to regulate the mass flow.

4. The device according to one of claims 1 to 3, **characterized in that** the delivery device is a pump.

5. The device according to one of claims 1 to 3, **characterized in that** the delivery device (8) controls the pressure which the liquid (6') is under in the reservoir (6).

6. The device according to one of claims 1 to 5, **characterized in that** the control unit controls the delivery device in order to regulate the mass flow.

7. The device according to one of claims 1 to 5, **characterized in that** the control unit controls the delivery device in such a manner that it could deliver a mass flow which is greater than the predetermined mass flow, and
**in that** there is at least one actuator which is controled by the control unit in order for the mass flow to be regulated and which sets the mass flow of the respective precursor to a predeterminable value.

8. The device according to claim 7, **characterized in that** the actuator is a valve which is provided in the line for the respective precursor.

9. The device according to claim 8, **characterized in that** the valve is a proportional valve, the opening cross section of which controls the control unit.

10. The device according to claim 7, **characterized in that** the actuator controls an injector which introduces the liquid precursor into the evaporation region.

11. The device according to one of claims 1 to 10, **characterized in that** there is at least one evaporation chamber (4), in which the precursor (6') or at least one of the plurality of liquid precursors evaporates, and which is connected to at least one inlet into the reactor chamber (1), such as for example a showerhead (5).

12. The device according to claim 11, **characterized in that** the actuator controls the passage of the evaporated precursors from the evaporation chamber into the reactor chamber.

13. The device according to one of claims 1 to 11, **characterized in that** the injector(s) introduce the precursor(s) directly into the reactor chamber, so that the evaporation region is part of the reactor chamber.

14. The device according to one of claims 1 to 13, **characterized in that** the injectors are two-fluid or multifluid nozzles, and **in that** one fluid is the carrier gas.

15. The device according to one of claims 1 to 14, **characterized in that** the sensor unit records the quantity of precursors supplied in the liquid phase.

16. The device according to one of claims 1 to 14, **characterized in that** the sensor unit records the quantity of precursors supplied in or following the evaporation region.

17. The device according to claim 16, **characterized in that** the sensor unit records the quantity of precursors supplied in the evaporated phase in the region of a gas inlet into the reactor chamber, such as for example the showerhead (5).

18. The device according to one of claims 1 to 17, **characterized in that** the control unit controls the temperature of the precursor(s) to values which can in each case be predetermined, if appropriate on a local basis.

19. The device according to claim 18, **characterized in that** the sensor unit records the temperature of the liquid precursor(s) in the reservoir(s) and/or in the line(s).

20. The device according to claim 19, **characterized in that** the output signal from the temperature sensor unit is applied to the control unit as an actual signal.

21. The device according to claim 19 or 20, **characterized in that** the control unit controls the temperature of the precursors to in each case predeterminable values.

22. The device according to one of claims 1 to 21, **characterized in that** there is more than one evaporation region for each precursor.

23. The device as claimed in claim 22, **characterized in that** the control unit subjects the mass flow which is fed to each evaporation region to open- or closed-loop control independently of the mass flows which are fed to the other evaporation regions for the same precursor.

24. The device according to one of claims 1 to 23, **characterized in that** the sensor unit records the distribution of the evaporated precursors in the reactor chamber.

25. The device according to claim 24, **characterized in that** the output signal from the sensor unit is applied to the control unit for regulation of the mass flow which is fed to each of the evaporation regions.

26. The device according to one of claims 1 to 25, **characterized in that** a temperature-control unit is provided, which sets the temperature of the liquid in the reservoir(s), in the feed line(s), in the actuator(s) and/or in the evaporation region(s) to predeterminable values.

27. The device according to claim 26, **characterized in that** the temperature-control unit has a cooling unit which cools the precursor(s) upstream of the evaporation region to a temperature which is lower than the evaporation temperature at the pressure in the evaporation region.

28. The device according to claim 26 or 27, **characterized in that** the temperature-control unit, at a given pressure in the reactor chamber, sets a temperature profile which is such that the temperature in the evaporation region of the precursor(s) is above the evaporation temperature for the corresponding pressure in the evaporation region.

29. The device according to claim 28, **characterized in that** surfaces whose temperature can be controled are disposed in the evaporation region.

30. The device according to one of claims 1 to 29, **characterized in that**, when more than one precursor is being used, the precursors are present in mixed form in the reservoirs and/or various precursors, which are each stored in separate reservoirs, are mixed in accordance with a predeterminable mixing ratio in the liquid state in the evaporator region, in the region of the gas inlet (showerhead) into the reactor chamber and/ or only in the reactor chamber.

31. The device according to claim 30, **characterized in that** there are static mixing elements which effect mixing of the individual liquid precursors.

32. The device according to one of claims 1 to 31, **characterized in that** at least one inlet for a carrier gas and/ or a process gas is provided in the reactor chamber and/ or the evaporation region(s).

33. The device according to one of claims 5 to 32, **characterized in that** the precursor is disposed in a deformable container which is in a pressure-resistant vessel, and **in that** the container, for delivery of the precursor, is acted on by a gas located in the vessel in such a manner that as a result there is no free liquid surface.

34. A process for depositing at least one precursor, which is in liquid or dissolved form, on at least one substrate, in which the precursors, which are in individual or mixed form, are delivered by a delivery device via at least one line into at least one evaporation region, so that they form the films on the substrate arranged in a reactor chamber, **characterized in that** the quantity of precursors supplied is recorded, and **in that** the mass flow of the precursors, taken as a mean over a certain period of time, is set to a predeterminable value.

35. The use of the process according to claim 34 for producing thin films on substrates.

## Revendications

1. Dispositif pour déposer au moins un précurseur se présentant sous forme liquide ou dissoute sur au moins un substrat, avec
- au moins un réservoir (6) pour le ou les précurseurs (6'), seul(s) ou en mélange,
- une chambre de réacteur (1) dans laquelle le ou les substrats sont disposés, sur lequel ou lesquels au moins une couche doit être appliquée,
- une installation d'alimentation (8) qui fournit le ou les précurseurs, au moyen d'au moins une conduite (7) reliée au(x) réservoir(s) (6), à au moins une zone (4) dans laquelle le ou les précurseurs (6') doivent être vaporisés, et
- une unité de commande, qui commande l'installation d'alimentation (8),
**caractérisé en ce qu'**une unité de détection (41, 42) est prévue pour mesurer la quantité de précurseurs fournie par unité de temps, et dont le signal de sortie est appliqué en tant que signal de valeur actuelle à l'unité de commande, et
**en ce que** l'unité de commande règle l'installation d'alimentation (8) de façon à ce que le courant de masse moyen des précurseurs a, de manière standardisée, une valeur prédéfinissable pendant une durée déterminée.

2. Dispositif selon la revendication 1, **caractérisé en ce que** l'unité de commande pour la régulation du courant de masse met en marche et arrête l'alimentation en précurseurs sans intervalle de temps fermement prédéfini.

3. Dispositif selon la revendication 1, **caractérisé en ce que** l'unité de commande pour la régulation du courant de masse réalise une alimentation en précurseurs continue.

4. Dispositif selon l'une des revendications 1 à 3, **caractérisé en ce que** l'installation d'alimentation est constituée d'une pompe.

5. Dispositif selon l'une des revendications 1 à 3, **caractérisé en ce que** l'installation d'alimentation (8) commande la pression sous laquelle le liquide (6') se trouve dans le réservoir (6).

6. Dispositif selon l'une des revendications 1 à 5, **caractérisé en ce que** l'unité de commande pour la régulation du courant de masse commande l'installation d'alimentation.

7. Dispositif selon l'une des revendications 1 à 5, **caractérisé en ce que** l'unité de commande commande l'installation d'alimentation, de telle sorte qu'elle puisse fournir un courant de masse supérieur au courant de masse prédéfini, et **en ce qu'**il est prévu au moins un élément de réglage, qui est commandé par l'unité de commande en vue du réglage du courant de masse et qui règle le courant de masse de chaque précurseur à une valeur prédéfinie.

8. Dispositif selon la revendication 7, **caractérisé en ce que** l'élément de réglage est une vanne qui est prévue dans la conduite pour chaque précurseur.

9. Dispositif selon la revendication 8, **caractérisé en ce que** la vanne est une vanne proportionnelle, dont la section d'ouverture est commandée par l'unité de commande.

10. Dispositif selon la revendication 7, **caractérisé en ce que** l'élément de réglage commande un injecteur qui fait passer le précurseur liquide dans la zone de vaporisation.

11. Dispositif selon l'une des revendications 1 à 10, **caractérisé en ce qu'**il est prévu au moins une chambre de vaporisation (4), dans laquelle le précurseur (6') ou du moins une pluralité de précurseurs liquides se vaporisent, et qui est reliée à au moins une entrée de la chambre de réacteur (1), comme par exemple une pomme d'arrosage (5).

12. Dispositif selon la revendication 11, **caractérisé en ce que** l'élément de réglage commande le passage des précurseurs vaporisés de la chambre de vaporisation à la chambre de réacteur.

13. Dispositif selon l'une des revendications 1 à 11, **caractérisé en ce que** le ou les injecteurs introduisent le ou les précurseurs directement dans la chambre de réacteur, de sorte que la zone de vaporisation est une partie de la chambre de réacteur.

14. Dispositif selon l'une des revendications 1 à 13, **caractérisé en ce que** les injecteurs sont des gicleurs à deux ou plusieurs jets et **en ce que** l'un des jets est un jet de gaz porteur.

15. Dispositif selon l'une des revendications 1 à 14, **caractérisé en ce que** l'unité de détection mesure la quantité de précurseurs fournis en phase liquide.

16. Dispositif selon l'une des revendications 1 à 14, **caractérisé en ce que** l'unité de détection mesure la quantité de précurseurs fournis dans ou après la zone de vaporisation.

17. Dispositif selon la revendication 16, **caractérisé en ce que** l'unité de détection mesure la quantité de précurseurs fournis en phase vapeur dans la zone d'une entrée de gaz de la chambre de réacteur, comme par exemple la pomme d'arrosage (5).

18. Dispositif selon l'une des revendications 1 à 17, **caractérisé en ce que** l'unité de commande règle la température du ou des précurseurs à chaque valeur prédéfinie, localement le cas échéant.

19. Dispositif selon la revendication 18, **caractérisé en ce que** l'unité de détection mesure la température du ou des précurseurs liquides dans le ou les réservoirs et/ou dans la ou les conduites.

20. Dispositif selon la revendication 19, **caractérisé en ce que** le signal de sortie de l'unité de détection de température est reliée en tant que signal de valeur réelle de l'unité de commande.

21. Dispositif selon la revendication 19 ou la revendication 20, **caractérisé en ce que** l'unité de commande règle la température des précurseurs à chacune des valeurs prédéfinissables.

22. Dispositif selon l'une des revendications 1 à 21, **caractérisé en ce qu'**il est prévu pour chaque précurseur plus d'une zone de vaporisation.

23. Dispositif selon la revendication 22, **caractérisé en ce que** l'unité de commande commande ou règle le courant de masse qui est fourni à chaque zone de vaporisation, indépendamment des courants de masse qui sont fournis aux autres zones de vaporisation pour le même précurseur.

24. Dispositif selon l'une des revendications 1 à 23, **caractérisé en ce que** l'unité de détection mesure la répartition des précurseurs vaporisés dans la chambre de réacteur.

25. Dispositif selon la revendication 24, **caractérisé en ce que** le signal de sortie de l'unité de détection est appliqué à l'unité de commande pour la régulation du courant de masse fourni à chacune des zones de vaporisation.

26. Dispositif selon l'une des revendications 1 à 25, **caractérisé en ce qu'**est prévue une unité d'équilibrage, qui règle à des valeurs prédéfinissables la température du liquide dans le ou les réservoirs, dans la ou les conduites, dans le ou les éléments de réglage et/ou dans la ou les zones de vaporisation.

27. Dispositif selon la revendication 26, **caractérisé en ce que** l'unité d'équilibrage présente une unité de thermostatisation, qui refroidit le ou les précurseur(s) avant la zone de vaporisation, à une température inférieure à la température de vaporisation sous la pression de la zone de vaporisation.

28. Dispositif selon la revendication 26 ou la revendication 27, **caractérisé en ce que** l'unité de thermostatisation établit pour une pression donnée dans la chambre de réacteur un profil de température, tel que la température dans la zone de vaporisation du ou des précurseurs se situe au-dessus de la température de vaporisation pour la pression correspondante dans la zone de vaporisation.

29. Dispositif selon la revendication 28, **caractérisé en ce que** des surfaces thermostatisables sont disposées dans la zone de vaporisation.

30. Dispositif selon l'une des revendications 1 à 29, **caractérisé en ce que**, lors de l'utilisation de plus d'un précurseur, les précurseurs se trouvent mélangés dans les réservoirs, et/ou différents précurseurs stockés individuellement dans des réservoirs séparés sont mélangés selon un rapport de mélange prédéfinissable à l'état liquide, dans la zone de vaporisation, dans la zone de l'entrée de gaz (pomme d'arrosage) dans la chambre de réacteur, et/ou seulement dans la chambre de réacteur.

31. Dispositif selon la revendication 30, **caractérisé en ce que** des éléments de mélange statique sont prévus pour effectuer le mélange des différents précurseurs liquides.

32. Dispositif selon l'une des revendications 1 à 31, **caractérisé en ce que**, dans la chambre de réacteur et/ou dans la ou les zones de vaporisation, il est prévu au moins une entrée pour un gaz porteur et/ou un gaz de procédé.

33. Dispositif selon l'une des revendications 5 à 32, **caractérisé en ce que** le précurseur se trouve dans un récipient résistant à la pression, qui est disposé dans un conteneur solide, et **en ce que** le récipient est introduit, en vue de l'alimentation en précurseur, par un gaz se trouvant dans le conteneur, de telle sorte qu'il ne crée aucune surface de liquide libre.

34. Procédé pour déposer au moins un précurseur se présentant sous forme liquide ou dissoute sur au moins un substrat, dans lequel les précurseurs se présentant seuls ou en mélange sont fournis par une installation d'alimentation à au moins une zone de vaporisation au moyen d'au moins une conduite, de telle sorte qu'ils forment les couches sur le substrat disposé dans une chambre de réacteur, **caractérisé en ce que** la quantité de précurseurs fournis est mesurée, et **en ce que** le courant de masse des précurseurs moyenné sur une durée déterminée est réglé à une valeur prédéfinissable.

35. Utilisation du procédé selon la revendication 34 pour la réalisation de couches minces sur des substrats.
